# DEMANDE DE BREVET EUROPEEN

(11) **EP 1 659 634 A2**
(43) Date de publication de la demande: **24.05.2006**
(21) Numéro de dépôt: 05110847.0
(22) Date de dépôt: 17.11.2005
(51) Int. Cl.: H01L 29/737, H01L 21/331, H01L 29/201, H01L 29/205

(54) **Transistor bipolaire et procédé de fabrication de ce transistor**

(30) Priorité: 18.11.2004 FR 0452670
(71) Demandeur: ALCATEL, 75008 Paris (FR)
(72) Inventeur: Blayac, Sylvain, 13105 Mimet (FR); Scavennec, André, 75013 PARIS (FR)
(74) Mandataire: Fournier, Michel Robert Marie

(57) **Abrégé**

L'invention propose un transistor bipolaire, comprenant un substrat, des couches d'émetteur, de base et de collecteur et, le cas échéant, des couches de contact. La couche de base est en un matériau GaAsSb. Le transistor présente en outre au moins une couche de transition en un matériau GaInP, entre la couche d'émetteur et la couche de base. La présence et la composition de la couche de transition permettent de modeler le dessin de la bande de conduction du transistor de sorte à en optimiser les performances. En outre, la composition de la couche de transition facilite la fabrication par gravure sélective du transistor.

L'invention concerne également un circuit comprenant un transistor bipolaire selon l'invention.

L'invention propose en outre un procédé de fabrication d'un transistor selon l'invention

## Description

L'invention concerne un transistor bipolaire ainsi qu'un procédé de fabrication d'un tel transistor.

Dans ce qui suit, on désigne par semi-conducteur un matériau dont la conductivité électrique se situe entre celle des conducteurs et celle des isolants et varie en fonction de la concentration d'impuretés ou dopants. Le dopage d'un semi-conducteur consiste à introduire dans sa masse des atomes d'une impureté choisie, en vue d'en influencer - localement ou globalement - la conductivité.

On appelle « bande d'énergie » un ensemble de niveaux d'énergie discrets rapprochés d'un matériau et, plus particulièrement d'un solide cristallin. Ces niveaux sont susceptibles d'être occupés par des électrons, ils se substituent aux niveaux de l'atome isolé dans la matière condensée. Par exemple, la « bande de conduction » est une bande vide ou partiellement occupée, dans laquelle les électrons sont susceptibles de porter un courant (dit de conduction). La « bande de valence » est une bande de plus faible énergie que la précédente, occupée par des électrons qui ne participent pas à la conductibilité électrique. On désigne par « largeur de bande interdite » l'intervalle correspondant à l'énergie minimale nécessaire à un électron pour passer d'un niveau situé dans la bande de valence à un niveau de la bande de conduction.

Lors d'une excitation d'un électron depuis la bande de valence vers la bande de conduction, tout se passe comme si un « trou » était créé dans la bande de valence. Ce trou peut être modélisé comme une particule de charge opposée à celle de l'électron et susceptible de porter un courant électrique.

On entend par « recombinaison » une désexcitation d'un électron, par exemple de la bande de conduction vers la bande de valence ou encore une annihilation d'une paire électron/trou. Cette désexcitation peut être stimulée ou spontanée.

Les transistors sont des composants à base de semi-conducteur utilisés pour contrôler le passage d'un courant électrique ; ils constituent l'élément de base des circuits électroniques. Un transistor comprend principalement trois couches semiconductrices (les couches dites « d'émetteur », « de base » et « de collecteur ») séparées par deux jonctions. Les couches peuvent être dopées « positif » (noté P) ou « négatif » (N). On distingue deux types de transistors : le transistor NPN (émetteur N, base P, collecteur N) et le transistor PNP (émetteur P, base N, collecteur P).

Vu de manière plus détaillée, dans un transistor bipolaire NPN classique à homojonction, les électrons passent de l'émetteur au collecteur. Ce transistor comprend deux jonctions PN : émetteur-base et base-collecteur, montées tête-bêche. En fonctionnement normal, la jonction émetteur-base est polarisée en direct, ce qui permet une injection préférentielle des porteurs majoritaires de l'émetteur (électrons) dans la base, à condition que le dopage de cette dernière soit plus faible que celui de l'émetteur. Ces porteurs diffusent vers la jonction base-collecteur polarisée en inverse. Le champ électrique créé dans cette zone de champ, appelée zone de charge d'espace ou zone déplétée, favorise alors une collection des électrons dans le collecteur. Un fonctionnement à très haute fréquence impose cependant, à la fois une base de faible épaisseur, pour obtenir un faible temps de transit des électrons à travers celle-ci, ainsi qu'un fort dopage de la base, afin d'obtenir une faible résistance de base, ce qui est nécessaire pour réduire les temps de charge de type résistance x capacité. Un fort dopage de base, avec un dopage encore plus élevé de l'émetteur pour conserver du gain, conduit à une capacité de la jonction émetteur-base très forte, qui limite donc le fonctionnement à haute fréquence.. Il devient alors nécessaire de modifier la structure des couches pour se libérer de cette contrainte, par exemple en utilisant une hétérojonction base-émetteur.

Un transistor bipolaire est dit à simple hétérojonction (ou SHBT, de l'anglais « single-heterojunction bipolar transistor ») lorsque les deux couches semiconductrices contiguës (formant la jonction émetteur-base) sont de compositions atomiques différentes et n'ont par conséquent pas la même largeur de bande interdite, tout en ayant, le cas échéant, même paramètre de maille. On utilise alors un émetteur ayant une largeur de bande interdite Eg supérieure à celle de la base. On peut par exemple utiliser des matériaux InP (Eg = 1,35 eV) et InGaAs (Eg = 0,75 eV), respectivement pour l'émetteur et la base. Une telle combinaison permet, pour un dopage modéré de l'émetteur, de doper fortement la base afin d'en diminuer la résistance tout en lui conservant une faible épaisseur. L'avantage de la structure des transistors bipolaires à hétérojonction sur celle des transistors à homojonction réside donc dans la possibilité d'augmenter les performances en fréquence tout en conservant un gain élevé. Un tel transistor à hétérojonction émetteur-base InP/InGaAs est bien adapté à un fonctionnement à basse tension.

Lorsque de hautes tensions doivent être utilisées, il devient nécessaire d'améliorer la tension de claquage.

A cette fin, on peut utiliser des transistors bipolaires à double hétérojonction (ou DHBTs), c'est-à-dire qui présentent une seconde hétérojonction base-collecteur en plus de l'hétérojonction émetteur-base. La seconde hétérojonction a pour effet d'améliorer la tension de claquage grâce à l'utilisation d'un matériau à largeur de bande interdite élevée (par exemple l'InP) pour le collecteur. Cependant, cette seconde hétérojonction crée une discontinuité dans la bande de conduction, appelée « spike ». Dans le cas d'une jonction émetteur-base polarisée en direct, ce spike présente un avantage car les électrons sont injectés dans la base avec une énergie excédentaire. En revanche, il bloque les électrons à la jonction base-collecteur et dégrade ainsi le gain du transistor.

Une solution à ce problème consiste à insérer des couches de transition entre la base et le collecteur afin d'adoucir les variations de la bande de conduction ; on obtient ce-faisant un transistor avec des caractéristiques très correctes. Bien que largement adoptée, cette solution n'est cependant pas totalement satisfaisante lorsque de hautes densités de courant-collecteur sont utilisées. La charge résultant des électrons en transit provoque une déformation des bandes importante au niveau de l'hétérojonction base-collecteur et un blocage des électrons se produit au niveau de la base.

En outre, la structure multi-couches du collecteur implique des procédés technologiques de fabrication plus complexes du fait du comportement des couches de GaInAsP et de leurs interfaces lors de la gravure chimique ainsi que des courants de fuite importants du fait de la présence de multiples interfaces dans une région de fort champ électrique, ce qui limite en retour la tension de claquage.

Un autre schéma d'alignement de bande de conduction a été proposé dans le document US 5,349,20, afin de résoudre le problème de collection au niveau de l'interface base-collecteur. Dans ce document, il est proposé un transistor bipolaire à hétérojonction comprenant une couche de collecteur InGaAs, InP ou AlInAs formée au-dessus d'un substrat InP. La couche de base, en GaAsSb (et plus particulièrement GaAs0.53Sb0.47), est formée au-dessus de la couche de collecteur, et la couche d'émetteur, en AlInAs ou InP, est formée au-dessus de la couche de base. La couche de base peut être en GaAsSb dopé au béryllium ou au carbone.

L'alignement de bande de conduction ainsi obtenu permet une collection efficace des électrons, puisque la bande de conduction du collecteur en InP, par exemple, se trouve naturellement en dessous du niveau de celle de la base, en GaAsSb (d'environ 0,17 eV pour des matériaux en accord de maille), formant ainsi ce qui est connu comme une hétérojonction de type II. L'efficacité de ce concept a été clairement démontrée (voir par exemple l'article de M.W. Dvorak, C.R. Bolognesi, O.J. Pitts, S.P. Watkins, "300 GHz InP/GaAsSb/InP Double HBTs with High Current Capability and BVCEO > 6 V", IEEE Electron Dev. Lett. 22 (8), 361-363 (2001)). La configuration proposée résulte en des caractéristiques de transistor tout à fait acceptables et ce, sans recourir à des couches de transition, soit sans interfaces supplémentaires. Les processus associés sont ainsi simplifiés et la jonction collecteur-base offre des qualités améliorées, que ce soit en mode statique ou dynamique.

Cependant, dans le cas d'un transistor à émetteur en InP, le positionnement relatif des bandes de conduction, favorable dans le cas d'une jonction collectrice (cas de la jonction base-collecteur) est défavorable dans le cas de l'hétérojonction émetteur-base où la discontinuité crée un puits de potentiel (ou « notch » en anglais) dans la bande de conduction en condition de polarisation directe. Ce puits de potentiel a des effets non-désirables sur (i) le gain en courant, à faible densité de courant, du fait des recombinaisons engendrées à l'hétérojonction émetteur-base ; (ii) la capacité de la jonction émetteur-base, qui croit en raison de l'accumulation d'électrons à la jonction et (iii) les conditions d'injection d'électrons dans la base.

Afin de résoudre le problème créé à la jonction émetteur-base, un matériau de base désaccordé (par rapport au paramètre de maille de l'InP) riche en arsenic (permettant de réduire la valeur de la discontinuité, a été utilisé avec un certain succès par l'équipe précédente. Par ailleurs, il a été proposé (voir par exemple P. Bove, H. Lahreche, R. Langer, "InP/GaAsSb and (AI,Ga)InAs/ GaAsSb DHBT material grown in a 4 inches multiwafer MBE machine", Proc. Indium Phosphide & Related Materials Conférence ; IEEE Catalog 02CH37307 ; pp 607 - 610 ; 2002) de remplacer le matériau InP de l'émetteur par un matériau quaternaire GalnAlAs, lequel permet de supprimer le puits de potentiel précité en annulant la discontinuité, et de restaurer le gain en courant à faible courant.

D'autres matériaux pour l'émetteur ont été testés à cette même fin, par exemple le matériau InAlAs accordé en maille à l'InP. Ce type de matériau, utilisé pour l'émetteur, permet d'obtenir une discontinuité des bandes de conduction inversée par rapport à une hétérojonction InP/GaAsSb, autorisant une injection quasi-balistique des électrons, ce qui se traduit a priori par un temps de transit minimum à travers la base. Néanmoins, ces dernières solutions (matériaux en AllnAs ou AlGalnAs pour la couche d'émetteur) présentent certains inconvénients d'ordre technologique. Les deux types de matériaux précités limitent les possibilités d'utilisation de procédés par gravure sélective. Ils ne permettent notamment pas de stopper naturellement la gravure chimique au niveau de la couche de base lors de la formation de l'émetteur. Cet aspect est tout particulièrement important lorsque de hauts rendements de fabrication sont souhaités comme, par exemple, pour la fabrication de circuits intégrés.

Il existe donc un besoin pour un transistor bipolaire à haute performance, adapté à être fabriqué par gravure sélective, ainsi qu'un procédé de fabrication d'un tel transistor.

L'invention propose ainsi un transistor bipolaire comprenant : un substrat, une couche de collecteur, une couche de base en un matériau GaAsSb, une couche d'émetteur et au moins une couche de transition en un matériau GaInP, entre la couche d'émetteur et la couche de base.

Dans des modes de réalisation, le transistor bipolaire selon l'invention comprend une ou plusieurs des caractéristiques suivantes :
- le substrat est en matériau InP, la couche d'émetteur est en un matériau InP et la couche de collecteur est en un matériau InP ;
- la couche de transition est en un matériau de composition Ga1-xInxP, l'indice x étant compris entre 0,60 et 1,00 ;
- l'indice x est sensiblement compris entre 0,82 et 1,00 ;
- la couche de transition est en un matériau de composition Ga1-xInxP, d'indice x variable, sensiblement égal à 1,00 à l'interface entre la couche de transition et la couche d'émetteur et supérieur à 0,60 à l'interface entre la couche de transition et la couche de base ;
- l'indice x est sensiblement égal à 0,82 à l'interface entre la couche de transition et la couche de base ;
- le transistor selon l'invention comporte une pluralité de couches de transition, chacune des couches de transition comprenant une composition Ga1-xlnxP d'indice x compris entre 1,00 et une valeur supérieure à 0,60, les valeurs d'indice x étant sensiblement décroissante de l'émetteur à la base ;
- l'indice x de chacune des couches est supérieur à 0,82 ;
- l'indice x de la couche de transition varie sensiblement continûment d'une valeur supérieure à 0,60 à 1,00, entre la couche de base et la couche d'émetteur ;
- l'indice x varie sensiblement continûment de 0,82 à 1,00, entre la couche de base et la couche d'émetteur ; et
- la base en GaAsSb a un paramètre de maille désaccordé par rapport au paramètre de maille de la couche d'émetteur.

L'invention concerne également un circuit comprenant un transistor bipolaire selon l'invention.

L'invention propose en outre un procédé de fabrication d'un transistor selon l'invention, comprenant une étape (a) de formation de ladite au moins une couche de transition en un matériau GaInP.

Dans des modes de réalisation, le procédé selon l'invention comprend l'une des caractéristiques suivantes :
- l'étape (a) de formation de la couche de transition est une étape de croissance par épitaxie sélective de la couche de transition ; et
- l'étape (a) de formation de la couche de transition est une étape de gravure sélective de la couche de transition.

D'autres caractéristiques et avantages de l'invention apparaîtront à la lecture de la description qui suit des modes de réalisation de l'invention, donnés à titre d'exemple et en référence aux dessins annexés, qui montrent :
- Figure 1 : une représentation schématique de l'alignement de bandes d'un transistor bipolaire selon un mode de réalisation de l'invention;
- Figure 2 : un exemple de diagramme de bandes obtenu selon le mode de réalisation de la figure 1 ;
- Figure 3 : une représentation schématique de l'alignement de bandes d'un transistor bipolaire selon un autre mode de réalisation de l'invention ; et
- Figure 4 : un exemple de diagramme de bandes obtenu selon le mode de réalisation de la figure 3.
- Figure 5 : une représentation schématique de l'alignement de bandes d'un transistor bipolaire selon un troisième mode de réalisation de l'invention ;
- Figure 6 : un exemple de diagramme de bandes obtenu selon le mode de réalisation de la figure 5

L'invention propose un transistor bipolaire, comprenant un substrat, des couches d'émetteur, de base et de collecteur et, le cas échéant, des couches de contact. La couche de base est en un matériau GaAsSb. Le transistor présente en outre au moins une couche de transition en un matériau GaInP, entre la couche d'émetteur et la couche de base. La présence et la composition de la couche de transition permettent de modeler le dessin de la bande de conduction du transistor de sorte à en optimiser les performances. En outre, la composition de la couche de transition facilite la fabrication par gravure sélective du transistor.

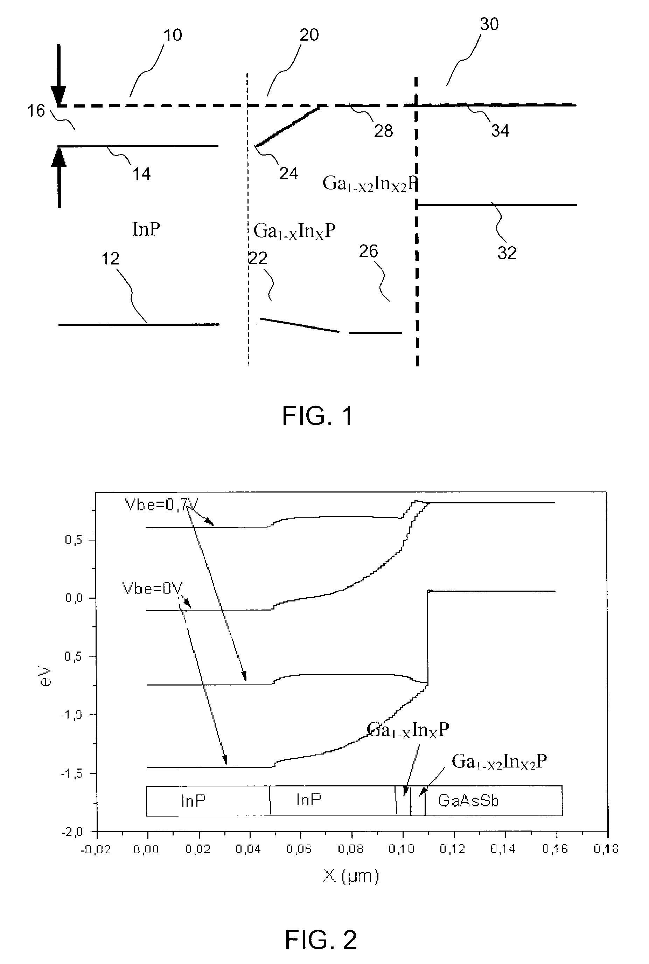

La figure 1 représente schématiquement l'alignement de bandes des matériaux d'émetteur, de la couche de transition et de base d'un transistor bipolaire selon un mode de réalisation de l'invention. L'axe des ordonnées repère des niveaux d'énergie, sans échelle et l'axe des abscisses est confondu avec une direction privilégiée du transistor. Cette direction, notée X, est sensiblement perpendiculaire aux couches successives d'émetteur, de transition et de base du transistor bipolaire selon l'invention. Les zones correspondantes sur la figure 1 sont respectivement repérées par les numéros de références 10, 20 et 30. Ces zones sont séparées par des lignes verticales en pointillé sur la figure 1. Une première série de segments 14, 24, 28, 34 symbolise l'alignement de bande de conduction selon la direction X. Une deuxième série de segments 12, 22, 26, 32 symbolise l'alignement de bande de valence. Plus précisément, les segments 14, 24 et 28 ensembles, et 34 représentent respectivement les valeurs caractéristiques des énergies de la bande de conduction des couches d'émetteur, de transition et de base du transistor. De même, les segments 12, 22 et 26 ensembles, et 32 représentent respectivement des valeurs caractéristiques des énergies de la bande de valence des couches d'émetteur, de transition et de base du transistor. L'écart entre les deux flèches de la figure 1 représente un écart caractéristique en énergie entre la bande de conduction de la couche d'émetteur et celle de la couche de base du transistor bipolaire. Cet écart est typiquement de 0,17 eV lorsqu'une couche d'émetteur InP et une couche de base GaAsSb en accord de maille sont utilisées.

En référence à la figure 1, le transistor bipolaire selon l'invention présente au moins une couche de transition en un matériau GaInP, entre la couche d'émetteur et la couche de base, laquelle est en un matériau GaAsSb, dopé. La composition de la couche de transition, c'est-à-dire un alliage ternaire GaInP, permet une fabrication du transistor par gravure sélective, du fait de la présence du phosphore. La gravure stoppe naturellement sur la base GaAsSb, ce qui permet de conserver une épaisseur de base constante de façon homogène et donc d'obtenir d'excellents rendements.

De préférence, la couche de base est en un matériau GaAsSb, dopé ayant sensiblement la composition GaAs0.51Sb0.49, ce qui permet un accord maille avec le matériau InP.

De préférence également, le substrat du transistor et la couche d'émetteur sont en un matériau InP, respectivement semi-isolant et dopé. La couche de collecteur est, de préférence également, en un matériau InP dopé. Le transistor bipolaire selon l'invention est alors un transistor bipolaire à double hétérojonction, offrant ainsi les avantages discutés ci-dessus.

Il est cependant possible de prévoir un substrat en GaAs, tandis que la couche de collecteur est, elle, en un matériau InP. Dans un tel cas, une croissance métamorphique est réalisée sur le substrat de GaAs. Une couche tampon est insérée entre le substrat et la couche de collecteur afin d'absorber la différence de paramètres de maille respectifs. Une épitaxie métamorphique permet de réaliser des structures de bonne qualité cristallographique bien que présentant un paramètre de maille notablement différent de celui du substrat sur lequel elles sont déposées.

Dans un mode de réalisation, la couche de transition est en un matériau de composition Ga1-xInxP où l'indice x peut être ajusté. L'ajustement de la composition de la couche permet alors de modeler la bande de conduction, en particulier au niveau de la jonction émetteur-base.

De préférence, cet indice x est compris entre 0,60 et 1,00. L'indice x peut par exemple être fixé à la valeur 0,82 au niveau de l'interface entre la couche de transition et la couche de base. Lorsque cet indice est réduit à 0,82 environ au niveau de cette interface, la discontinuité de bande de conduction disparaît pratiquement, c'est-à-dire que le saut d'énergie Ec(GaInP/GaAsSb) devient sensiblement nul à l'interface, pour une composition de base GaAs0.51Sb0.49. La valeur approchée de 0,82 a été calculée par interpolation des informations connues relatives aux positions du niveau de Fermi et de l'énergie de bande interdite dans les matériaux InP et GaP (voir par exemple H. Hasegawa and H. Ohno, J. Vac. Sci. Technol., B4 (1986), pp 1130). Ainsi, les effets indésirables liés à la discontinuité de la bande de conduction au niveau de la jonction émetteur-base sur le gain de courant et la capacité émetteur-base sont-ils diminués, voire supprimés. La réduction ou la suppression de la discontinuité permet en effet d'obtenir un gain en courant amélioré, dû à une diminution du phénomène de recombinaison au niveau de la jonction et une plus faible capacité (l'accumulation de charges parasitiques au niveau de la discontinuité étant elle-même diminuée).

Selon un mode de réalisation, il est possible d'améliorer encore les conditions d'injection dans la base en choisissant un indice plus faible que 0,82 (par exemple sensiblement égal à 0,70), provoquant ainsi l'apparition d'une discontinuité permettant une injection quasi-balistique des porteurs (électrons) dans la base.

Dans un mode de réalisation de l'invention, l'indice x de la couche de transition passe de 0,82 à 1,00, entre la couche de base et la couche d'émetteur. La valeur de l'indice au niveau de l'interface entre la couche de transition et la couche de base, soit 0,82, permet de supprimer la discontinuité de bande de conduction, comme discuté ci-avant. La valeur de l'indice au niveau de l'interface émetteur-couche de transition est 1,00, si bien que la composition de la couche de transition est sensiblement la même que celle de la couche d'émetteur à cet endroit. L'interface est donc graduelle, il n'y a donc pas non plus de discontinuité de la bande de conduction à cet endroit, ce qui empêche des phénomènes électroniques indésirables, comme discuté plus haut.

L'indice x peut par exemple varier sensiblement continûment entre 1,00 et 0,82, dans le sens émetteur-base, auquel cas toute discontinuité de bande est supprimée, comme symbolisé par les segments 20 et 22 sur la figure 1.

Le cas échéant, deux couches de transition peuvent être aménagées, l'une de composition Ga1-xInxP où l'indice x est progressif (variant continûment de 1,00 à 0,82 dans le sens émetteur ― base) et l'autre de composition Ga1-x2Inx2P où x2 = 0,82. Une telle configuration de couches de transition permet l'obtention d'une forme adéquate de la bande de conduction, sans discontinuité notable ou variation brusque.

La figure 2 représente un exemple de diagramme de bandes obtenu selon le mode de réalisation de la figure 1. L'axe des ordonnées repère des niveaux d'énergie (électron-volt ou eV) et l'axe des abscisses est confondu avec une direction privilégiée du transistor, de même que dans la figure 1, mais ici les bandes de conduction et de valence de la partie fortement dopée en InP de l'émetteur sont également représentées, dans la partie gauche de la figure. La figure 2 représente le résultat d'une simulation physique pour différentes conditions de polarisation. Dans un premier cas, il existe une tension base-émetteur (Vbe), fixée par le courant de polarisation voisine de 0,7 volts, et représentative des conditions de polarisation normales, tandis que dans le second cas, cette tension est nulle. Les deux courbes supérieures selon l'axe des énergies représentent l'évolution de la bande de conduction, les deux courbes inférieures représentent la bande de valence. L'épaisseur relative des couches émetteur - transition - base est montrée à l'aide d'une échelle figurant au bas de la figure.

Dans le mode de réalisation de la figure 2, cette échelle concerne des couches successives d'InP (dopé à 1.1019 cm-3), d'InP (dopé à 3.1017 cm-3), de Ga1-xlnxP (dopé à 1.1016 cm-3, d'indice x progressif et continu), de GaInP (dopé à 1.1016 cm-3, d'indice x2 = 0,82) et de GaAsSb (dopé à 3.1019 cm-3).

La simulation physique a été opérée à l'aide d'un logiciel, développé au laboratoire Opto+ d'Alcatel Recherche & Innovation (voir par exemple F. Palmier, "Notice de BCBV", Rapport Interne CNET France Télécom, 1998). Ce logiciel permet de simuler des structures en fonction des couches épitaxiales qui les composent, de leurs dopages et de la polarisation, afin de modéliser des propriétés physiques telles que les diagrammes de bandes, la densité de porteurs et de courant, le profil du champ électrique, etc. L'obtention de diagrammes du type de la figure 2 est utile à l'homme de l'art pour l'appréciation des caractéristiques du transistor. Un tel diagramme peut incorporer le résultat de mesures expérimentales, par exemple du type photoluminescence ou électro-réflectance, mais il doit nécessairement faire appel à un modèle car il n'existe pas de possibilité de mesure directe de la fonction représentée en figure 2, d'où la simulation.

Comme le montre la figure 2, l'insertion de couches de transition dont l'une est de composition Ga1-xInxP où l'indice x est progressif (variant continûment de 1,00 à 0,82) et l'autre de composition Ga1-x2Inx2P (x2 = 0,82) permet de redessiner l'évolution des bandes, en particulier de la bande de conduction de sorte à en minimiser les discontinuités, et ce, aussi bien pour Vbe = 0,7 V que pour Vbe = 0,0 V.

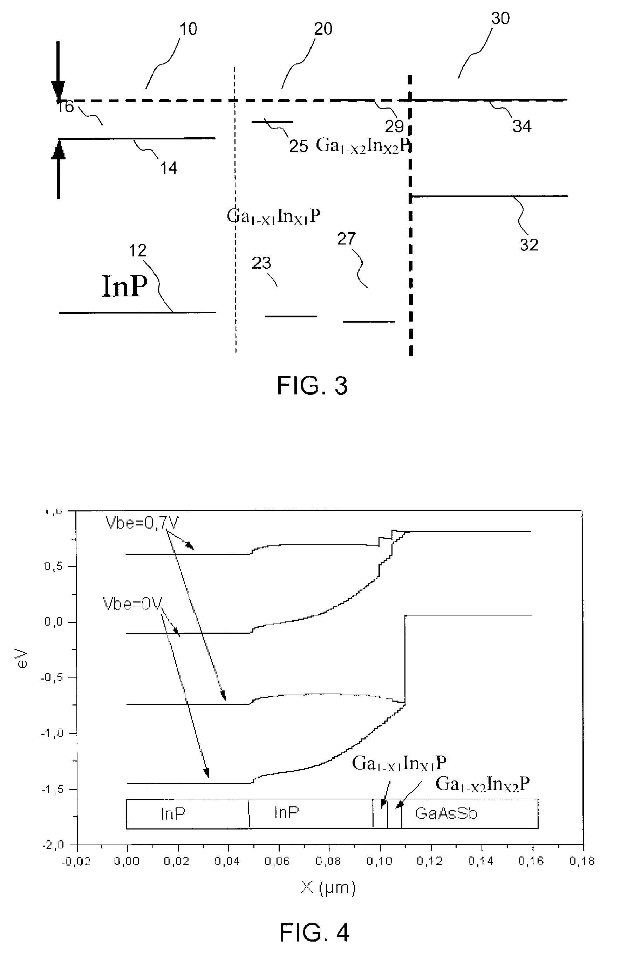

La figure 3 représente schématiquement l'alignement de bandes d'un transistor bipolaire selon un autre mode de réalisation de l'invention. La figure 3 reprend les mêmes numéros de référence que la figure 1, à ceci près que ce sont les segments 25 et 29 qui symbolisent maintenant la bande de conduction selon la direction X au niveau de la couche de transition (de même les segments 23 et 27 pour la bande de valence).

Dans le mode de réalisation de la figure 3, l'indice x varie par saut, de façon discontinue: il y a dans ce cas une ou plusieurs couches de transition, chacune de ces couches ayant un indice x distinct. Les discontinuités persistantes obtenues dans ce mode de réalisation sont toutefois inférieures à celle obtenue dans le cas d'une jonction de type InP/GaAsSb, c'est à dire d'une jonction émetteur-base sans couche de transition.

Il est par exemple possible de ne prévoir qu'une seule couche de transition, ayant une composition Ga1-x1Inx1P dans laquelle l'indice x1 a une valeur intermédiaire entre les valeurs 0,82 et 1, permettant respectivement une discontinuité réduite à l'interface couche de transition - couche de base et à l'interface couche d'émetteur - couche de transition par rapport à la discontinuité apparaissant en l'absence de couche de transition. Cette valeur de l'indice x1 peut par exemple être fixée à 0,9. La présence, ne serait-ce que d'une seule couche de transition d'indice x compris entre les valeurs 0,82 et 1 permet de diminuer la discontinuité de bande au niveau de l'interface d'entrée dans la base.

A l'instar du mode de réalisation de la figure 3, il est possible de prévoir deux couches de transition, l'une d'indice x1 de valeur intermédiaire sensiblement constante et égale à 0,91 et l'autre d'indice x2 sensiblement constant et égal à 0,82. La valeur 0,82 permet de supprimer la discontinuité à l'interface couche de transition ― couche de base tandis que la valeur 0,91 est une valeur intermédiaire qui permet de répartir les discontinuités autour de cette couche, comme représenté schématiquement sur la figure 3.

Recourir à une ou plusieurs couches de transition Ga1-xInxP d'indice x graduel, c'est-à-dire variant par saut, permet de diminuer les discontinuités de bande au niveau de la jonction émetteur ― base. Il en résulte des propriétés de gain et de capacité parasite améliorées. L'utilisation de dispositifs optimisés de transistor bipolaire selon l'invention permet en outre d'envisager des fréquences de coupure bien supérieures à 300 GHz et des gains en courant de l'ordre de 100. Dans le même temps, la fabrication de tels transistors bipolaires se trouve grandement améliorée, étant donné que la possibilité de gravure sélective émetteur ― base est préservée, du fait notamment de la composition de la ou les couche(s) de transition.

De préférence, l'épaisseur d'une couche de transition est inférieure à 40 nm et de plus grande préférence inférieure à 30 nm. Une épaisseur type de couche de transition est de l'ordre de 20 nm et ce, qu'il s'agisse d'une couche de transition dont l'indice x est constant ou progressif. De telles épaisseurs de couches permettent de restreindre les effets néfastes des désaccords de maille entre les couches d'émetteur et de base, et la couche de transition.

Il est à noter que le paramètre de maille d'une simple couche de transition Ga1-xlnxP d'indice x = 0,82 (soit a = 5,79 angströms, structure de type ZnS) n'est pas identique à celui de l'InP (a = 5,87 angströms, même structure cristallographique). Le désaccord de maille se traduit donc par un écart relatif de 1,4 %. Une telle valeur d'écart reste néanmoins relativement faible, au regard des désaccords de mailles habituellement admis dans l'art (pour des épaisseurs de couche désaccordée de l'ordre de 20 nm).

La figure 4 représente un exemple de diagramme de bandes obtenu selon le mode de réalisation de la figure 3. La figure 4 est semblable, dans sa présentation, à la figure 2. La simulation physique a également été opérée à l'aide d'un logiciel de simulation numérique.

Dans le mode de réalisation de la figure 4, l'échelle figurant au bas de la figure concerne des couches successives d'InP (dopé à 1.1019 cm-3), d'InP (dopé à 3.1017 cm-3), de Ga1-x1Inx1P (dopé à 1.1016 cm-3, d'indice x1 = 0,91), de Ga1-x2Inx2P (dopé à 1.1016 cm-3, d'indice x2 = 0,82) et de GaAsSb (dopé à 3.1019 cm-3).

Comme le montre la figure 4, l'insertion de couches de transition d'indice x graduel permet également de modeler les bandes, en particulier la bande de conduction de sorte à en minimiser les discontinuités (dans le cas Vbe = 0,7 V ou Vbe = 0,0 V). La présence des deux couches de transition induit deux légères discontinuités en amont de la base, côté émetteur. Chacune de ces discontinuités est toutefois inférieures à celle obtenue pour une simple jonction InP/GaAsSb (typiquement 0,17 eV). L'insertion de couches de transition d'indice x constant permet donc de diviser l'amplitude des discontinuités de la bande de conduction et de restreindre ainsi les effets indésirables discutés ci-avant.

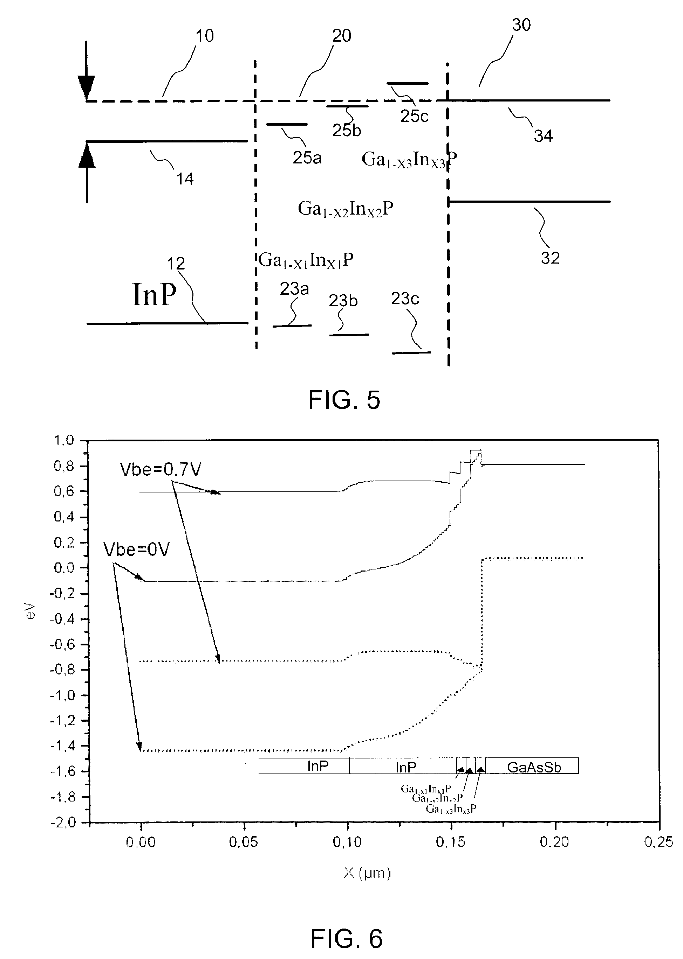

La figure 5 représente schématiquement l'alignement de bandes d'un transistor bipolaire selon un troisième mode de réalisation de l'invention. Dans ce mode de réalisation, on cherche à améliorer les conditions de transport à travers la base, grâce à une discontinuité telle que l'hétérojonction entre la dernière couche de transition et la base Ga1-x31nx3P / GaAsSb soit de type I. La figure 5 reprend les mêmes numéros de référence que la figure 1, à ceci près que ce sont les segments 25a, 25b et 25c qui symbolisent maintenant la bande de conduction selon la direction X au niveau de la couche de transition (de même les segments 23a, 23b et 23c pour la bande de valence).

Dans le mode de réalisation de la figure 5, l'indice x varie de façon discontinue, comme pour le cas de la figure 3. Cet indice x prend successivement les valeurs x1, x2 et x3, de telle sorte que la bande de conduction de la couche de transition la plus proche de la base soit située au dessus de la bande de conduction de cette dernière.

La figure 6 représente un exemple de diagramme de bandes obtenu selon le mode de réalisation de la figure 5. La figure 6 est semblable, dans sa présentation, aux figures 2 et 4. La simulation physique a également été opérée à l'aide d'un logiciel de simulation numérique.

En référence à la figure 6, l'échelle figurant au bas de la figure concerne des couches successives d'InP (dopé à 1.1019 cm-3), d'InP (dopé à 3.1017 cm-3), de Ga1-x1Inx1P (dopé à 1.1016 cm-3, d'indice x1 = 0,9), de Ga1-x2Inx2P (dopé à 1.1016 cm-3, d'indice x2 = 0,8), de Ga1-x3Inx3P (dopé à 1.1016 cm-3, d'indice x3 = 0,7) et de GaAsSb (dopé à 3.1019 cm-3).

A nouveau, comme le montre la figure 6, l'insertion de couches de transition d'indice x graduel permet de modeler les bandes, en particulier la bande de conduction de sorte à en minimiser les discontinuités. La présence des trois couches de transition induit trois légères discontinuités en amont de la base, côté émetteur. L'existence d'une discontinuité avec la base, telle que la bande de conduction de l'émetteur incluant la zone de transition soit située au dessus de la bande de conduction de la base permet d'injecter dans celle-ci des électrons énergétiques qui pourront la traverser plus rapidement que dans les cas précédents, améliorant encore les caractéristiques du transistor.

Comme discuté plus haut, le matériau de base a de préférence une composition proche de celle correspondant à l'accord de maille sur InP. Cependant, selon un mode de réalisation, le matériau de base GaAsSb est désaccordé (par rapport au paramètre de maille de la couche émetteur en InP), c'est-à-dire que le taux d'arsenic de la composition est légèrement augmenté (passant de 0,53 à 0,56 voire 0,60). Ceci permet de disposer d'un paramètre supplémentaire afin d'ajuster (en particulier de réduire) la discontinuité à la jonction émetteur-base.

Le transistor bipolaire selon l'invention peut en outre classiquement comprendre des parties métalliques de contact émetteur, de contact base, de contact collecteur, ainsi que des parties de contact en semi-conducteur comme le sous collecteur, etc. Les parties métalliques de contact sont par exemple en Ti/Pt/Au.

L'invention concerne également un circuit, en particulier un circuit intégré, comprenant une pluralité de transistors selon l'invention. En effet, les propriétés obtenues pour ce transistor et son potentiel de fabrication le rendent propice à son utilisation dans un circuit.

L'invention concerne également un procédé de fabrication d'un transistor selon l'invention.

Des processus technologiques de fabrication de transistors et de circuits à base d'InP sont connus et maîtrisés (voir par exemple S. Blayac, "Transistor bipolaire à double hétérojonction InP/InGaAs pour circuits de communications optiques à très haut débit", Thèse de doctorat, Université Montpellier II, 2000).

Le procédé selon l'invention peut tout d'abord comprendre des étapes préliminaires de croissance épitaxiale, notamment de la couche de collecteur, de la couche de base et de celle d'émetteur, comme il est connu de l'art.

A cet égard, des techniques classiques d'épitaxie peuvent être utilisée, telles que l'épitaxie dite MBE (« Molecular Beam Epitaxy ») ou épitaxie par jets moléculaires ou par la technique MOVPE (« Metal Organic Vapor Phase Epitaxy ») ou épitaxie en phase vapeur aux organométalliques. Ces techniques se sont largement diffusées. Il est encore possible de recourir à une technique d'épitaxie par jets chimiques ou CBE (de l'anglais « Chemical Beam Epitaxy »), laquelle mêle des aspects des deux techniques précédentes. En particulier, elle combine le concept du régime moléculaire de croissance à celui de l'utilisation de sources gazeuses (voir par exemple J.L. Benchimol, F. Alexandre, B. Lamare, P. Legay, "Benefits of chemical beam epitaxy for micro and optoelectronic applications", Prog. Cristal Growth and Charact., vol.3, pp.473-495, 1996,).

Les éléments des couches à déposer (par exemple l'Indium (In), le Gallium (Ga), l'Arsenic (As) et le Phosphore (P)) peuvent être obtenus par décomposition par pyrolyse ou craquage des sources à très haute température. Après craquage, les espèces en phase gazeuse viennent se déposer sur le substrat. Un vide est maintenu afin d'évacuer les produits non souhaités après décomposition, notamment des radicaux. De plus, une basse pression (~10-6 torr) offre un régime dans lequel le libre parcours moyen des molécules est supérieur à la distance source-substrat, ce qui permet aux espèces d'atteindre la surface du substrat sans subir d'interactions notables.

Le procédé selon l'invention peut typiquement comporter des étapes de lithographie, de dépôt, de gravure, de passivation et de planarisation. En particulier, ce procédé peut comprendre des étapes de lithographie du contact émetteur, de dépôt du contact émetteur (par exemple en Ti/Pt/Au) et, après gravure des couches de contact en GaInAs de l'émetteur, de gravure chimique du mesa émetteur InP. Une solution adaptée pour la gravure sélective de la partie en InP du mesa émetteur est du type HCl + H3PO4.

Une étape clé du procédé selon l'invention est la formation de ladite au moins une couche de transition en un matériau GaInP.

Dans un mode de réalisation de l'invention, cette étape comprend elle-même une étape de gravure sélective de la couche de transition. En ce qui concerne la gravure de la couche de transition, une solution adaptée est du même type que celle utilisée pour la couche d'InP, par exemple à base de H3PO4 et HCl. En raison des compositions impliquées (soit GaInP pour la couche de transition et

GaAsSb pour la base), la gravure chimique stoppe naturellement sur la base. Une telle caractéristique permet d'atteindre de hauts rendements de fabrication.

Le procédé selon l'invention peut en outre comprendre des étapes de lithographie du contact base, de dépôt du contact base (par exemple en Pt/Ti/Pt/Au) et de gravure chimique du mesa base.

Le procédé peut encore comprendre une ou plusieurs des étapes suivantes : lithographie du contact collecteur, dépôt du contact collecteur (Ti/Pt/Au), lithographie de protection (isolation), gravure chimique du mesa collecteur, passivation avec du polyimide, lithographie de vias, gravure des vias et dépôt d'un métal d'interconnexion (voir par exemple S. Withitsoonthorn, « Photodiode UTC et oscillateur différentiel commandé en tension à base de TBdH InP pour récupération d'horloge dans un réseau de transmission optique à très haut débit», Thèse de Doctorat de l'Université de Paris 6).

Selon un mode de réalisation, l'étape (a) de formation de la couche de transition est une étape de croissance par épitaxie sélective de la couche de transition, laquelle peut par exemple faire suite à une étape de formation de la couche de base. En effet, en fonction des gaz en présence dans le réacteur où est effectuée la croissance et en fonction de la nature du matériau en surface, le phénomène d'épitaxie peut ou non se produire. En d'autres termes, les conditions sont ajustées afin d'obtenir une croissance sélective.

Le transistor et le procédé de fabrication de ce transistor selon l'invention sont ainsi non seulement adaptés à la technique de gravure sélective mais ils sont également susceptibles d'utiliser la technique d'épitaxie sélective.

Les présents modes de réalisation et exemples doivent être considérés comme ayant été présentés à titre illustratif et non restrictif et l'invention n'est pas censée être limitée aux détails fournis ici mais peut être modifiée en restant dans le cadre de la portée des revendications annexées.

## Revendications

1. Transistor bipolaire, comprenant :
- un substrat en matériau InP;
- une couche de collecteur en un matériau InP;
- une couche de base en un matériau GaAsSb ;
- une couche d'émetteur en un matériau InP; et
- au moins une couche de transition en un matériau GaInP, entre la couche d'émetteur et la couche de base.

2. Le transistor de la revendication 1, dans lequel la couche de transition est en un matériau de composition Ga1-xInxP, l'indice x étant compris entre 0,60 et 1,00.

3. Le transistor de la revendication 2, dans lequel l'indice x étant sensiblement compris entre 0,82 et 1,00.

4. Le transistor de la revendication 1 dans lequel la couche de transition est en un matériau de composition Ga1-xInxP, d'indice x variable, sensiblement égal à 1,00 à l'interface entre la couche de transition et la couche d'émetteur et supérieur à 0,60 à l'interface entre la couche de transition et la couche de base.

5. Le transistor de la revendication 4, dans lequel l'indice x est sensiblement égal à 0,82 à l'interface entre la couche de transition et la couche de base.

6. Le transistor de la revendication 1, comportant une pluralité de couches de transition, chacune des couches de transition comprenant une composition Ga1-xlnxP d'indice x compris entre 1,00 et une valeur supérieure à 0,60, les valeurs d'indice x étant sensiblement décroissante de l'émetteur à la base.

7. Le transistor de la revendication 6, dans lequel l'indice x de chacune des couches est supérieur à 0,82.

8. Le transistor de la revendication 2, dans lequel l'indice x de la couche de transition varie sensiblement continûment d'une valeur supérieure à 0,60 à 1,00, entre la couche de base et la couche d'émetteur.

9. Le transistor de la revendication 8, dans lequel l'indice x varie sensiblement continûment de 0,82 à 1,00, entre la couche de base et la couche d'émetteur.

10. Le transistor de l'une quelconque des revendications 1 à 9, dans lequel la base en GaAsSb a un paramètre de maille désaccordé par rapport au paramètre de maille de la couche d'émetteur.

11. Circuit comprenant un transistor selon l'une des revendications 1 à10.

12. Procédé de fabrication d'un transistor selon l'une des revendications 1 à 10, comprenant une étape :
(a) de formation de ladite au moins une couche de transition en un matériau GaInP.

13. Le procédé de la revendication 12, dans lequel l'étape (a) de formation de la couche de transition est une étape de croissance par épitaxie sélective de la couche de transition.

14. Le procédé de la revendication 12, dans lequel l'étape (a) de formation de la couche de transition est une étape de gravure sélective de la couche de transition.
